# EUROPÄISCHE PATENTSCHRIFT

(11) **EP 3 350 857 B1**
(45) Veröffentlichungstag und Bekanntmachung des Hinweises auf die Patenterteilung: **17.02.2021**
(21) Anmeldenummer: 16763744.6
(22) Anmeldetag: 05.09.2016
(51) Int. Cl.: H01M 4/36, H01M 4/38, H01M 4/587, H01M 10/052, C23C 16/06, C23C 16/26, C23C 16/44

(54) **VORLITHIIERTES, KOHLENSTOFFBESCHICHTETES ANODENAKTIVMATERIAL**
PRELITHIATED, CARBON-COATED ANODE ACTIVE MATERIAL
MATÉRIAU ACTIF D'ANODE PRÉLITHIÉ REVÊTU DE CARBONE

(30) Priorität: 17.09.2015 DE 102015217809
(43) Veröffentlichungstag der Anmeldung: 25.07.2018
(73) Patentinhaber: Robert Bosch GmbH, 70442 Stuttgart (DE)
(72) Erfinder: VERMA, Pallavi, 70771 Leinfelden (DE); CHEN, Yunhua, Shanghai 200335 (CN); SCHUMANN, Bernd, 71277 Rutesheim (DE); ZHANG, Eric, Minhang Shanghai 200240 (CN)
(86) Internationale Anmeldenummer: PCT/EP2016/070822
(87) Internationale Veröffentlichungsnummer: WO 2017/045950

(56) Entgegenhaltungen:
- EP-A1- 2 634 845
- US-A1- 2010 173 198
- Stuart M Leeds: "Chapter 3 - Experimental", Characterisation of the Gas-Phase Environment in a Microwave Plasma Enhanced Diamond Chemical Vapour Deposition Reactor using Molecular Beam Mass Spectrometry (Ph.D. Thesis), 1. April 1999 (1999-04-01), XP055317478, Gefunden im Internet: URL:http://web.archive.org/web/20141012054 545/http://www.chm.bris.ac.uk/pt/diamond/s tuthesis/chapter3.htm [gefunden am 2016-11-08]

## Beschreibung

Die vorliegende Erfindung betrifft ein Verfahren zur Herstellung eines Anodenaktivmaterials für eine Lithium-Zelle, ein Anodenaktivmaterial, und eine Lithium-Zelle

### Stand der Technik

Silicium ist eines der vielversprechendsten Anodenmaterialien für die nächste Generation von Lithium-Ionen-Batterien, da Silicium eine sehr hohe Kapazität bietet, welche beispielsweise bei 3670 mA/g bei etwa 0,4 V gegen Lithium liegen und etwa um das Zehnfache höher als die Kapazität von Graphit sein kann.

Herkömmliche Anoden auf der Basis von Nanosilicium weisen jedoch in der Regel kein gutes Zyklisierungsverhalten auf, da beim Zyklisieren das Silicium extreme Volumenänderungen durchläuft. Beispielsweise kann das Silicium beim Lithiieren eine Volumenexpansion um bis zu etwa 300 % vollziehen.

Herkömmlicherweise wird während des ersten Zyklus einer Zelle beziehungsweise während der ersten Lithiierung eines Anodenaktivmaterials eine Festkörper-Elektrolyt-Grenzschicht, eine so genannte SEI-Schicht (SEI; Englisch: Solide Electrolyte Interface), aus Elektrolytzersetzungsprodukten auf der Oberfläche des Anodenmaterials ausgebildet.

Im Fall von Silicium als Anodenaktivmaterial kann eine SEI-Schicht aus Elektrolytzersetzungsprodukten gebildet werden. Die SEI-Schicht ist im Fall von Silicium jedoch instabil und bricht mit voranschreitender Volumenexpansion ständig auf und exponiert dem Elektrolyten neue Reaktionsoberfläche, was zu einer ständigen SEI-Bildung und schließlich zur Ausbildung einer inhomogenen Schicht mit vielen Rissen und anderen Defekten, welche die Schicht während der folgenden Zyklen anfällig gegenüber Brüchen machen, führen kann.

Die Druckschrift US 2010/0173198 A1 betrifft eine sekundäre Lithium-Ionen-Batterie mit einer vorlithiierten Anode.

Die Druckschrift US 2007/0099084 A1 betrifft eine hochkapazitive Elektrode und Herstellungsverfahren hierfür.

Die Druckschrift US 2012/0100438 A1 betrifft Komposite, welche ein hochkapazitives, poröses, durch eine Schale begrenztes Aktivmaterial enthalten.

### Offenbarung der Erfindung

Gegenstand der Erfindung ist ein Verfahren zur Herstellung eines Anodenaktivmaterials für eine Lithium-Zelle.

Unter einer Lithium-Zelle kann insbesondere eine elektrochemische Zelle, beispielsweise eine Batteriezelle, zum Beispiel eine sekundäre oder primäre Batteriezelle, verstanden werden, an deren elektrochemischer Reaktion Lithium beteiligt sind. Zum Beispiel kann eine Lithium-Zelle eine Lithium-Ionen-Zelle oder eine Lithium-Schwefel-Zelle oder eine Lithium Sauerstoff-Zelle, beispielsweise eine Lithium-Luft-Zelle, sein.

In dem Verfahren wird ein Anodenaktivmaterial lithiiert und mit Kohlenstoff beschichtet. Zum Beispiel kann in dem Verfahren ein Anodenaktivmaterial (zunächst) lithiiert und das lithiierte Anodenaktivmaterial (dann) mit Kohlenstoff beschichtet werden.

Im Rahmen einer Ausführungsform umfasst das Anodenaktivmaterial Silicium. Beispielsweise kann das Anodenmaterial aus Silicium ausgebildet sein.

Das Anodenaktivmaterial kann beispielsweise in Form von Anodenaktivmaterialpartikel ausgebildet sein. Dabei können die Anodenaktivmaterialpartikel Silicium umfassen oder daraus ausgebildet sein. Zum Beispiel kann das Anodenaktivmaterialpartikel in Form von Siliciumpartikel ausgebildet sein. Insbesondere können dabei, beispielsweise lithiierte, Anodenaktivmaterialpartikel, zum Beispiel Siliciumpartikel, mit Kohlenstoff beschichtet werden.

Durch das Lithiieren, welches insbesondere mit einer Lithiumlegierungsbildung einhergehen kann, expandiert das Anodenaktivmaterial, beispielsweise die Anodenaktivmaterialpartikel, zum Beispiel die Siliciumpartikel, so dass das lithiierte (und damit expandierte) Anodenaktivmaterial, beispielsweise die Anodenaktivmaterialpartikeln, zum Beispiel die Siliciumpartikel, mit dem Kohlenstoff beschichtet werden.

Das Verfahren ermöglicht vorteilhafterweise lithiiertes (und damit expandiertes) Anodenaktivmaterial, beispielsweise lithiierte (und damit expandierte) Anodenaktivmaterialpartikel, zum Beispiel Siliciumpartikel, mit einer stabilisierten Oberflächenschicht zu synthetisieren. Vorteilhafterweise kann so eine Anodenaktivmaterial bereitgestellt werden, welches insbesondere bis hin zu seinem maximalen Volumen, beispielsweise bis hin zu einem etwa Vierfachen seines Volumens, zum Beispiel auf ein 3,75-faches oder mehr seines Volumens, im Fall von vollständig lithiiertem Silicium (LiₘₐₓSi, beispielsweise mit (≥) 3,75 Li/Si, zum Beispiel Li_{3,75}Si oder Li_{4,4}Si), expandiert sein kann und eine Kohlenstoffoberflächenbeschichtung aufweist. Insbesondere können so vorteilhafterweise Anodenaktivmaterialpartikel, zum Beispiel Siliciumpartikel, bereitgestellt werden, welche insbesondere bis hin zu ihrem maximalen Volumen, beispielsweise bis zu einem etwa Vierfachen ihres Volumens, zum Beispiel auf ein 3,75-faches oder mehr ihres Volumens, im Fall vollständig lithiiertem Silicium (LiₘₐₓSi), expandiert sein können und eine Kohlenstoffoberflächenbeschichtung aufweisen. Dabei kann die Kohlenstoffoberflächenbeschichtung vorteilhafterweise als Schutzschicht und Elektrolyt-Barriere dienen sowie zudem elektrische Leitfähigkeit verleihen.

Durch das Beschichten mit Kohlenstoff kann vorteilhafterweise eine Schicht auf dem Anodenaktivmaterial, beispielsweise auf den Anodenaktivmaterialpartikeln, zum Beispiel Siliciumpartikeln, realisiert werden, welche eine gewisse mechanische Stabilität aufweisen und beispielsweise sowohl beim lithiumlegierungsbildungsbedingten Expandieren als auch beim lithiumlegierungsrückbildungsbedingten Schrumpfen des Anodenaktivmaterials, beispielsweise der Anodenaktivmaterialpartikel, zum Beispiel Siliciumpartikel, mechanisch stabil bleiben kann, insbesondere ohne - im Gegensatz zu einer auf unbehandeltem Silicium, beispielsweise herkömmlichen Siliciumpartikeln, ausgebildeten SEI-Schicht - beim Expandieren zu brechen und/oder ohne - insbesondere auch im Gegensatz zu einer auf vorlithiiertem Silicium, zum Beispiel vorlithiierten Siliciumpartikeln, ausgebildeten SEI-Schicht - beim Schrumpfen zu kollabieren.

Somit kann durch das Verfahren vorteilhafterweise kohlenstoffbeschichtetes und dadurch mechanisch stabilisiertes, vorlithiiertes Anodenaktivmaterial, beispielsweise Silicium, bereitgestellt werden.

Auf der Kohlenstoffbeschichtung kann vorteilhafterweise bereits während des ersten Zyklisierungszyklus - zum Beispiel wenn die Zellspannung einer, beispielsweise carbonathaltigen, Zelle unter 0,8 V sinkt - eine SEI-Schicht gebildet werden, welche vorteilhafterweise in den folgenden Zyklen stabil bleiben kann. Dabei kann die SEI-Schicht auf der Kohlenstoffbeschichtung insbesondere stabil bleiben, da der Kohlenstoff beim Lithiieren lediglich eine minimale oder sogar keine - beispielsweise im Fall einer vollständig lithiierten Kohlenstoffbeschichtung - Volumenexpansion vollzieht.

So kann wiederum vorteilhafterweise das Zyklisierungsverhalten einer damit ausgestatten Lithium-Zelle verbessert werden.

Im Rahmen einer weiteren Ausführungsform wird das Anodenaktivmaterial mittels chemischer Gasphasenabscheidung lithiiert. Durch chemische Gasphasenabscheidung kann vorteilhafterweise eine homogene Lithiierung des Anodenaktivmaterials erzielt werden. In Kombination mit einem im Folgenden erläuterten Beschichten mit Kohlenstoff mittels chemischer Gasphasenabscheidung kann so zudem die Prozessführung vereinfacht werden.

Bei dem Lithiieren des Anodenaktivmaterials mittels chemischer Gasphasenabscheidung kann insbesondere ein Lithium-Präkursor verwendet werden.

Im Rahmen einer Ausgestaltung dieser Ausführungsform umfasst oder ist der Lithium-Präkursor mindestens einen lithiierten Kohlenwasserstoff, beispielsweise mindestens ein lithiiertes Alkin, zum Beispiel lithiiertes Acetylen, und/oder mindestens einen lithiierten aromatischen Kohlenwasserstoff, zum Beispiel lithiiertes Toluol.

Im Rahmen einer weiteren Ausführungsform wird das, beispielsweise lithiierte, Anodenaktivmaterial mittels chemischer Gasphasenabscheidung mit Kohlenstoff beschichtet. Eine mittels chemischer Gasphasenabscheidung ausgebildete Kohlenstoffbeschichtung kann vorteilhafterweise eine besonders hohe Homogenität und/oder mechanische Stabilität aufweisen und sowohl beim lithiumlegierungsbildungsbedingten Expandieren als auch beim lithiumlegierungsrückbildungsbedingten Schrumpfen des Anodenaktivmaterials, insbesondere der Anodenaktivmaterialpartikel, mechanisch stabil bleiben. Durch chemische Gasphasenabscheidung kann zudem vorteilhafterweise die Dicke und/oder Morphologie der Beschichtung, beispielsweise in Form eines Films, gezielt eingestellt werden und eine große Auswahl an Kohlenstoff-Präkursoren eingesetzt werden, welche beispielsweise im Hinblick auf ein Einstellen einer gewünschten Morphologie und/oder Leitfähigkeit der Beschichtung ausgewählt werden können.

Bei dem Beschichten des lithiierten Anodenaktivmaterials mittels chemischer Gasphasenabscheidung kann insbesondere ein Kohlenstoff-Präkursor verwendet werden.

Im Rahmen einer Ausgestaltung dieser Ausführungsform umfasst oder ist der Kohlenstoff-Präkursor mindestens einen Kohlenwasserstoff, beispielsweise mindestens ein Alkin, zum Beispiel Acetylen, und/oder mindestens einen aromatischen Kohlenwasserstoff, zum Beispiel Toluol.

Das Lithiieren und Beschichten mit Kohlenstoff erfolgt erfindungsgemäß schrittweise, durch alternierend wiederholtes beispielsweise teilweises Lithiieren des Anodenaktivmaterials und Beschichten des teilweise lithiierten Anodenaktivmaterials mit Kohlenstoff, beispielsweise bis zum Erreichen einer vollständigen Lithiierung (und damit einer maximalen Expansion).

Im Rahmen der Erfindung welche auf einem schrittweisen Lithiieren und Beschichten mit Kohlenstoff basiert - wird das Lithiieren und Beschichten mit Kohlenstoff alternierend wiederholt. Durch alternierendes Lithiieren und Beschichten mit Kohlenstoff kann vorteilhafterweise die Kohlenstoffbeschichtung zum einen lithiiert und zum anderen durch die beim Lithiieren auftretende Volumenexpansion verdichtet werden, wodurch wiederum vorteilhafterweise die Stabilität der Kohlenstoffbeschichtung erhöht werden kann.

Im Rahmen einer weiteren, alternativen oder zusätzlichen Ausführungsform - welche auf einem schrittweisen Lithiieren und Beschichten mit Kohlenstoff basiert - wird in dem Verfahren das Anodenaktivmaterial teilweise lithiiert. Dabei kann insbesondere das teilweise lithiierthe Anodenaktivmaterial mit Kohlenstoff beschichtet werden. Zum Beispiel kann in dem Verfahren das Anodenaktivmaterial (zunächst) teilweise lithiiert und (dann) das teilweise lithiierthe Anodenaktivmaterial mit Kohlenstoff beschichtet werden.

Im Rahmen einer Ausgestaltung dieser Ausführungsform wird das teilweise lithiierte, kohlenstoffbeschichtete Anodenmaterial (dann) weiter teilweise lithiiert. Durch wiederholtes teilweises Lithiieren kann vorteilhafterweise die Kohlenstoffbeschichtung lithiiert und durch den lithiierungsbedingten Expansionsschritt verdichtet und auf diese Weise deren Stabilität erhöht werden.

Im Rahmen einer weiteren Ausgestaltung dieser Ausführungsform wird das weiter teilweise lithiierte, kohlenstoffbeschichtete Anodenaktivmaterial (dann) erneut mit Kohlenstoff beschichtet. Durch wiederholtes Kohlenstoffbeschichten kann vorteilhafterweise die Beschichtung weiter stabilisiert werden.

Beispielsweise können dabei Anodenaktivmaterialpartikel, zum Beispiel Siliciumpartikel, (zunächst) teilweise lithiiert und (dann) die teilweise lithiierten Anodenaktivmaterialpartikel, zum Beispiel Siliciumpartikel, mit Kohlenstoff beschichtet werden. Die teilweise lithiierten, kohlenstoffbeschichteten Anodenmaterialpartikel, zum Beispiel Siliciumpartikel, können (dann) beispielsweise weiter teilweise lithiiert werden. Die weiter teilweise lithiierten, kohlenstoffbeschichteten Anodenaktivmaterialpartikel, zum Beispiel Siliciumpartikel, können (dann) beispielsweise erneut mit Kohlenstoff beschichtet werden.

Im Rahmen einer weiteren Ausführungsform wird das teilweise Lithiieren und Beschichten mit Kohlenstoff alternierend wiederholt.

Im Rahmen der Erfindung wird das, insbesondere teilweise, Lithiieren und Beschichten mit Kohlenstoff mindestens zweifach, insbesondere mindestens zehnfach, beispielsweise mindestens zwanzigfach, alternierend wiederholt. So kann vorteilhafterweise eine besonders stabile Kohlenstoffoberflächenbeschichtung erzielt werden.

Im Rahmen einer weiteren Ausführungsform wird das, insbesondere teilweise, Lithiieren und Beschichten mit Kohlenstoff bis zum Erreichen einer durchschnittlichen Schichtdicke der Kohlenstoffbeschichtung in einem Bereich von ≥ 50 nm bis ≤ 0,5 µm alternierend wiederholt. So kann vorteilhafterweise eine besonders stabile Kohlenstoffoberflächenbeschichtung erzielt werden.

Im Rahmen einer weiteren Ausführungsform wird das, insbesondere teilweise, Lithiieren und Beschichten mit Kohlenstoff bis zum Erreichen einer vollständigen Lithiierung des Anodenaktivmaterials alternierend wiederholt. So kann vorteilhafterweise eine besonders stabile Kohlenstoffoberflächenbeschichtung erzielt werden, insbesondere welche selbst im expandiertesten Zustand des Anodenaktivmaterials, beispielsweise der Anodenaktivmaterialpartikel, zum Beispiel Siliciumpartikel, stabil ist.

Zum Beispiel kann das Anodenaktivmaterial bis zum Erreichen einer vollständigen Lithiierung alternierend wiederholt teilweises lithiiert und das teilweise lithiierte Anodenaktivmaterial mit Kohlenstoff beschichtet werden. Beispielsweise können dabei die Anodenaktivmaterialpartikel, zum Beispiel Siliciumpartikel, bis zum Erreichen einer vollständigen Lithiierung alternierend wiederholt teilweises lithiiert und die teilweise lithiierten Anodenaktivmaterialpartikel, zum Beispiel Siliciumpartikel, mit Kohlenstoff beschichtet werden.

Im Rahmen einer weiteren Ausführungsform wird das Anodenaktivmaterial, bezogen auf die durch das Anodenaktivmaterial maximal aufnehmbare stöchiometrische Lithiummenge, (jeweils - insbesondere bei jedem teilweisen Lithiieren) zu ≤ 20 % teilweise lithiiert. Insbesondere kann das Anodenaktivmaterial, bezogen auf die durch das Anodenaktivmaterial maximal aufnehmbare stöchiometrische Lithiummenge, (jeweils - insbesondere bei jedem teilweisen Lithiieren) zu ≤ 10 %, beispielsweise jeweils zu ≤ 5 %, teilweise lithiiert werden. Beispielsweise können dabei die Anodenaktivmaterialpartikel, zum Beispiel Siliciumpartikel, bezogen auf die durch die Anodenaktivmaterialpartikel beziehungsweise Siliciumpartikel maximal aufnehmbare stöchiometrische Lithiummenge, (jeweils - insbesondere bei jedem teilweisen Lithiieren) zu ≤ 20 %, insbesondere jeweils zu ≤ 10 %, beispielsweise jeweils zu ≤ 5 %, teilweise lithiiert werden.

Zum Beispiel kann das Verfahren die Verfahrensschritte:
a) teilweises Lithiieren von Anodenaktivmaterial und
b) Beschichten des teilweise lithiierten Anodenaktivmaterials mit Kohlenstoff, umfassen. Beispielsweise können dabei in Verfahrensschritt a) Anodenaktivmaterialpartikel, zum Beispiel Siliciumpartikel, teilweise lithiiert werden und in Verfahrensschritt b) die lithiierten Anodenaktivmaterialpartikel, zum Beispiel Siliciumpartikel, mit Kohlenstoff beschichtet werden.

Dabei umfasst das Verfahren weiterhin den Verfahrensschritt:
c) weiteres teilweises Lithiieren des teilweise lithiierten, kohlenstoffbeschichteten Anodenaktivmaterials. Dabei werden in Verfahrensschritt c) teilweise lithiierte, kohlenstoffbeschichtete Anodenaktivmaterialpartikel, zum Beispiel Siliciumpartikel, weiter teilweise.

Weiterhin umfasst das Verfahren dabei den Verfahrensschritt:
d) erneutes Beschichten des weiter teilweise lithiierten, kohlenstoffbeschichteten Anodenaktivmaterials mit Kohlenstoff. Dabei werden in Verfahrensschritt d) weiter teilweise lithiierte, kohlenstoffbeschichtete Anodenaktivmaterialpartikel, zum Beispiel Siliciumpartikel, mit Kohlenstoff erneut beschichtet. Insbesondere kann das Anodenaktivmaterial in Verfahrensschritt a) beziehungsweise in den Verfahrensschritten a) und c) jeweils zu ≤ 20 %, insbesondere jeweils zu ≤ 10 %, beispielsweise jeweils zu ≤ 5 %, bezogen auf die durch das Anodenaktivmaterial maximal aufnehmbare stöchiometrische Lithiummenge, teilweise lithiiert werden. Beispielsweise können die Anodenaktivmaterialpartikel, zum Beispiel Siliciumpartikel, jeweils zu ≤ 20 %, insbesondere jeweils zu ≤ 10 %, beispielsweise mit ≤ 5 %, bezogen auf die durch die Anodenaktivmaterialpartikel, zum Beispiel Siliciumpartikel, maximal aufnehmbare stöchiometrische Lithiummenge, teilweise lithiiert werden.

Dabei werden die Verfahrensschritte c) und d) mindestens zweifach, beispielsweise mindestens zehnfach, zum Beispiel mindestens zwanzigfach, alternierend wiederholt werden. Zum Beispiel können die Verfahrensschritte c) und d) bis zum Erreichen einer vollständigen Lithiierung alternierend wiederholt werden.

Im Rahmen einer anderen Ausführungsform wird das Anodenaktivmaterial, beispielsweise Silicium, insbesondere bis zum Erreichen einer vollständigen Lithiierung, vollständig lithiiert und dann mit Kohlenstoff beschichtet. Insbesondere können dabei die Anodenaktivmaterialpartikel, zum Beispiel Siliciumpartikel, insbesondere bis zum Erreichen einer vollständigen Lithiierung, vollständig lithiiert und dann mit Kohlenstoff beschichtet werden. So kann vorteilhafterweise eine Kohlenstoffoberflächenbeschichtung erzielt werden, welche selbst im expandiertesten Zustand der Anodenaktivmaterialpartikel, insbesondere Siliciumpartikel, stabil ist.

Im Rahmen einer weiteren Ausführungsform wird das Verfahren durch eine im Folgenden erläuterte Vorrichtung durchgeführt.

Hinsichtlich weiterer technischer Merkmale und Vorteile des erfindungsgemäßen Verfahrens wird hiermit explizit auf die Erläuterungen im Zusammenhang mit der Vorrichtung, dem erfindungsgemäßen Anodenaktivmaterial und der erfindungsgemäßen Lithium-Zelle sowie auf die Figuren und die Figurenbeschreibung verwiesen.

Ein weiterer Gegenstand ist eine chemische Gasphasenabscheidungsvorrichtung zur Herstellung eines Anodenaktivmaterials für eine Lithium-Zelle.

Die Vorrichtung kann insbesondere einen Reaktionsraum, beispielsweise in Form einer Röhre, zur Durchführung von chemischer Gasphasenabscheidung, einen Lithium-Präkursor-Einlass zum Einlassen eines Lithium-Präkursors in den Reaktionsraum und ein Lithium-Präkursor-Einlass-Absperrorgan zum öffenbaren Absperren des Lithium-Präkursor-Einlasses sowie einen Kohlenstoff-Präkursor-Einlass zum Einlassen eines Kohlenstoff-Präkursors in den Reaktionsraum und ein Kohlenstoff-Präkursor-Einlass-Absperrorgan zum öffenbaren Absperren des Kohlenstoff-Präkursor-Einlasses umfassen.

Durch das Lithium-Präkursor-Einlass-Absperrorgan und das Kohlenstoff-Präkursor-Einlass-Absperrorgan können vorteilhafterweise die beiden Einlässe für den Lithium- und Kohlenstoff-Präkursor, insbesondere der Lithium-Präkursor-Einlass und der Kohlenstoff-Präkursor-Einlass, kontrolliert werden. So kann das Lithiieren und Beschichten vorteilhafterweise schrittweise oder in einem Schritt durchgeführt werden.

Das Lithium-Präkursor-Einlass-Absperrorgan und das Kohlenstoff-Präkursor-Einlass-Absperrorgan können beispielsweise Ventile sein. Insbesondere können das Lithium-Präkursor-Einlass-Absperrorgan und das Kohlenstoff-Präkursor-Einlass-Absperrorgan automatisch steuerbar sein. Beispielsweise können das Lithium-Präkursor-Einlass-Absperrorgan und das Kohlenstoff-Präkursor-Einlass-Absperrorgan alternierend öffenbar sein.

Im Rahmen einer Ausführungsform ist in einer Lithiierungsstellung das Lithium-Präkursor-Einlass-Absperrorgan geöffnet und das Kohlenstoff-Präkursor-Einlass-Absperrorgan geschlossen und/oder in einer Beschichtungsstellung das Lithium-Präkursor-Einlass-Absperrorgan geschlossen und das Kohlenstoff-Präkursor-Einlass-Absperrorgan geöffnet.

In dem Reaktionsraum kann beispielsweise eine Anodenaktivmaterialaufnahme zur Aufnahme von, zum Beispiel pulverförmigem, Anodenaktivmaterial vorgesehen sein. Die Anodenaktivmaterialaufnahme kann beispielsweise ein, insbesondere offener, Behälter sein.

Die Vorrichtung kann beispielsweise zur Herstellung eines Anodenaktivmaterials für eine Lithium-Ionen-Zelle oder eine Lithium-Schwefel-Zelle oder eine Lithium Sauerstoff-Zelle, beispielsweise eine Lithium-Luft-Zelle, ausgelegt sein.

Die Vorrichtung kann insbesondere zur Durchführung eines erfindungsgemäßen Verfahrens ausgelegt sein beziehungsweise dieses durchführen.

Hinsichtlich weiterer technischer Merkmale und Vorteile der Vorrichtung wird hiermit explizit auf die Erläuterungen im Zusammenhang mit dem erfindungsgemäßen Verfahren, dem erfindungsgemäßen Anodenaktivmaterial und der erfindungsgemäßen Lithium-Zelle sowie auf die Figuren und die Figurenbeschreibung verwiesen.

Ein weiterer Gegenstand ist ein Anodenaktivmaterial für eine Lithium-Zelle. Das Anodenaktivmaterial kann beispielsweise ein Anodenaktivmaterial für eine Lithium-Ionen-Zelle oder eine Lithium-Schwefel-Zelle oder eine Lithium Sauerstoff-Zelle, beispielsweise eine Lithium-Luft-Zelle, sein.

Im Rahmen der Erfindung ist das Anodenaktivmaterial durch ein erfindungsgemäßes Verfahren hergestellt.

Im Rahmen einer weiteren Ausführungsform umfasst das Anodenaktivmaterial Anodenaktivmaterialpartikel, beispielsweise Siliciumpartikel, welche mit mindestens zwei lithiierten Kohlenstoffbeschichtungen, beispielsweise mit mindestens zehn lithiierten Kohlenstoffbeschichtungen, zum Beispiel mit mindestens zwanzig lithiierten Kohlenstoffbeschichtungen, beschichtet sein. Ein derartiges Anodenaktivmaterial kann vorteilhafterweise durch schrittweises Lithiieren und Beschichten mit Kohlenstoff hergestellt werden.

Mittels eines erfindungsgemäßen Verfahrens und/oder mittels einer erfindungsgemäßen Vorrichtung hergestelltes Anodenaktivmaterial kann beispielsweise mittels Transmissionselektronenmikroskopie (TEM) und/oder Elektronenenergieverlustspektroskopie (EELS; Englisch: Electron Energy Loss Spectroscopy) und/oder Rasterelektronenmikroskopie (SEM; Englisch: Scanning Electron Microscope) und/oder Raman-Spektroskopie, Röntgenphotoelektronenspektroskopie (XPS, Englisch: X-ray Photoelectron Spectroscopy), beispielsweise mit Tiefenprofilierung, nachgewiesen werden.

Hinsichtlich weiterer technischer Merkmale und Vorteile des erfindungsgemäßen Anodenaktivmaterials wird hiermit explizit auf die Erläuterungen im Zusammenhang mit dem erfindungsgemäßen Verfahren, der Vorrichtung und der erfindungsgemäßen Lithium-Zelle sowie auf die Figuren und die Figurenbeschreibung verwiesen.

Ferner betrifft die Erfindung eine Lithium-Zelle welche ein erfindungsgemäßes Anodenmaterial umfasst. Die Lithium-Zelle kann zum Beispiel eine Lithium-Ionen-Zelle oder eine Lithium-Schwefel-Zelle oder eine Lithium Sauerstoff-Zelle, beispielsweise eine Lithium-Luft-Zelle, sein.

Hinsichtlich weiterer technischer Merkmale und Vorteile der erfindungsgemäßen Zelle wird hiermit explizit auf die Erläuterungen im Zusammenhang mit dem erfindungsgemäßen Verfahren, der Vorrichtung und dem erfindungsgemäßen Anodenaktivmaterial sowie auf die Figuren und die Figurenbeschreibung verwiesen.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen
- Fig. 1: ein Schema zur Veranschaulichung einer Ausführungsform des erfindungsgemäßen Verfahrens, im Rahmen derer Siliciumpartikel schrittweise und alternierend wiederholt teilweise lithiiert und mit Kohlenstoff beschichtet werden;
- Fig. 2: ein Schema zur Veranschaulichung einer anderen Ausführungsform des erfindungsgemäßen Verfahrens, im Rahmen derer Siliciumpartikel in einem Schritt vollständig lithiiert werden und dann mit Kohlenstoff beschichtet werden; und
- Fig. 3: einen schematischen Querschnitt durch eine Ausführungsform einer chemischen Gasphasenabscheidungsvorrichtung.

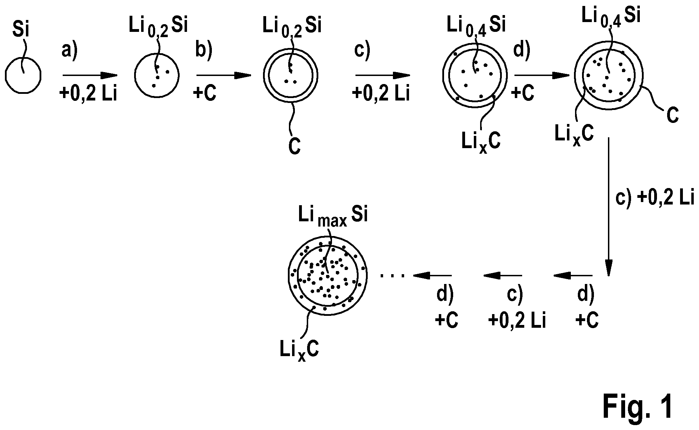

Figur 1 zeigt, dass im Rahmen einer Ausführungsform des erfindungsgemäßen Verfahrens Siliciumpartikel (Si) schrittweise lithiiert und mit Kohlenstoff (C) beschichtet werden. Die Siliciumpartikel (Si) werden dabei insbesondere in einem Verfahrensschritt a) teilweises lithiiert. Dabei werden die Siliciumpartikel (Si) pro Siliciumatom mit 0,2 Lithiumatomen lithiiert. Bezogen auf die durch das Silicium maximal aufnehmbare stöchiometrische Lithiummenge Liₘₐₓ, zum Beispiel von 3,75 beziehungsweise 4,4 Lithiumatomen pro Siliciumatom (Li_{3,75}Si, Li₄₄Si), werden die Siliciumpartikel (Si) in Verfahrensschritt a) somit zu etwa 5 % teilweise lithiiert. Figur 1 veranschaulicht, dass dabei teilweise lithiierte Siliciumpartikel (Li_{0,2}Si) ausgebildet werden.

Figur 1 illustriert, dass in einem Verfahrensschritt b) dann die teilweise lithiierten Siliciumpartikel (Li_{0,2}Si) mit Kohlenstoff (C) beschichtet werden. Figur 1 veranschaulicht, dass dabei teilweise lithiierte, kohlenstoffbeschichtete Siliciumpartikel (Li_{0,2}Si,C) ausgebildet werden.

Figur 1 zeigt, dass in einem Verfahrensschritt c) die teilweise lithiierten, kohlenstoffbeschichteten Siliciumpartikel (Li_{0,2}Si,C) dann weiter teilweise lithiiert werden. Dabei werden die Siliciumpartikel wieder pro Siliciumatom mit 0,2 Lithiumatomen beziehungsweise - bezogen auf die durch das Silicium maximal aufnehmbare stöchiometrische Lithiummenge Liₘₐₓ, zum Beispiel von 3,75 beziehungsweise 4,4 Lithiumatomen pro Siliciumatom (Li_{3,75}Si, Li_{4,4}Si) - wieder zu etwa 5 % teilweise lithiiert. Dabei kann auch der Kohlenstoff der Kohlenstoffbeschichtung lithiiert (LiₓC) werden. Figur 1 veranschaulicht, dass dabei weiter teilweise lithiierte, kohlenstoffbeschichtete Siliciumpartikel (Li_{0,4}Si,LiₓC) ausgebildet werden.

Figur 1 veranschaulicht, dass dann in einem Verfahrensschritt d) die weiter teilweise lithiierten, kohlenstoffbeschichteten Siliciumpartikel (Li_{0,4}Si,LiₓC) erneut mit Kohlenstoff (C) beschichtet werden. Figur 1 veranschaulicht, dass dabei erneut kohlenstoffbeschichtete, weiter teilweise lithiierte Siliciumpartikel (Li_{0,4}Si,LiₓC,C) ausgebildet werden.

Figur 1 deutet an, dass die Verfahrensschritte c) und d) mehrfach, beispielsweise zwanzigfach, alternierend wiederholt werden können.

Figur 1 zeigt, dass dabei die Verfahrensschritte c) und d) insbesondere bis zum Erreichen einer vollständigen Lithiierung der Siliciumpartikel (LiₘₐₓSi,LiₓC) alternierend wiederholt werden können.

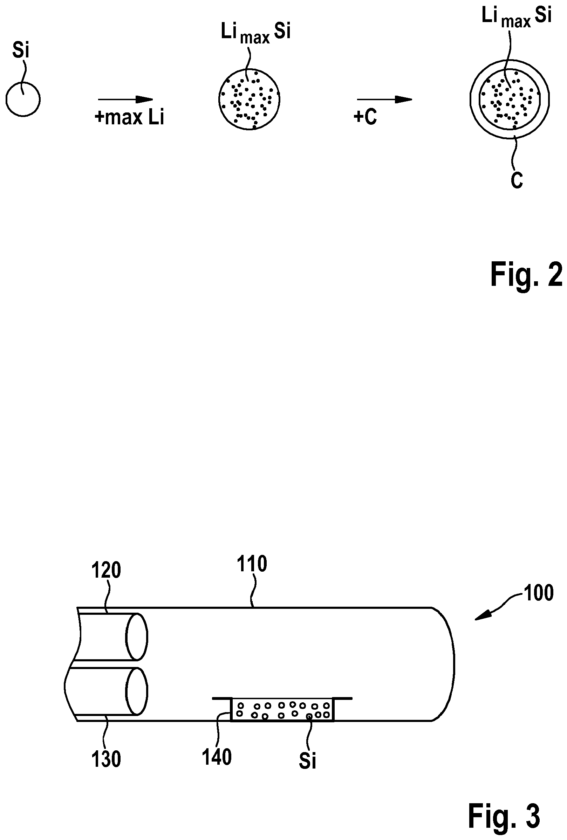

Figur 2 zeigt, dass im Rahmen einer anderen Ausführungsform des Verfahrens Siliciumpartikel (Si) in einem Schritt vollständig lithiiert (max Li) werden, wobei vollständig lithiiertes Silicium (LiₘₐₓSi), zum Beispiel Li_{3,75}Si beziehungsweise Li_{4,4}Si, ausgebildet wird. Die vollständig lithiierten Siliciumpartikel (LiₘₐₓSi) werden dann mit Kohlenstoff (C) beschichtet, wobei eine Kohlenstoffbeschichtung (C) ausgebildet wird. Allerdings ist eine Ausführungsform, welche auf einem einmaligen Beschichten mit Kohlenstoff in einem Schritt basiert, nicht Teil der Erfindung.

Figur 3 zeigt eine Ausführungsform einer chemischen Gasphasenabscheidungsvorrichtung 100 zur Herstellung eines Anodenaktivmaterials für eine Lithium-Zelle. Figur 1 zeigt, dass dabei die Vorrichtung 100 einen Reaktionsraum 110, beispielsweise eine CVD-Röhre, zur Durchführung von chemischer Gasphasenabscheidung aufweist. In dem Reaktionsraum 100 ist dabei eine Anodenaktivmaterialaufnahme 140 zur Aufnahme von Anodenaktivmaterial, zum Beispiel Silicium (Si), vorgesehen.

Figur 3 zeigt weiterhin, dass die Vorrichtung 100 einen Lithium-Präkursor-Einlass 120 zum Einlassen eines Lithium-Präkursors in den Reaktionsraum 110 und einen Kohlenstoff-Präkursor-Einlass 130 zum Einlassen eines Kohlenstoff-Präkursors in den Reaktionsraum 110 aufweist. Der Lithium-Präkursor-Einlass 120 ist dabei mit einem Lithium-Präkursor-Einlass-Absperrorgan (nicht dargestellt) zum öffenbaren Absperren des Lithium-Präkursor-Einlasses 120 ausgestattet. Der Kohlenstoff-Präkursor-Einlass 130 ist dabei mit einem Kohlenstoff-Präkursor-Einlass-Absperrorgan (nicht dargestellt) zum öffenbaren Absperren des Kohlenstoff-Präkursor-Einlasses 130 ausgestattet.

Durch das Lithium-Präkursor-Einlass-Absperrorgan und das Kohlenstoff-Präkursor-Einlass-Absperrorgan können vorteilhafterweise der Lithium-Präkursor-Einlass 120 und der Kohlenstoff-Präkursor-Einlass 130 kontrolliert werden, so dass das Lithiieren und Beschichten vorteilhafterweise in einer Vorrichtung 100 beispielsweise sowohl schrittweise als auch in einem Schritt durchgeführt werden kann.

Dabei kann das Lithium-Präkursor-Einlass-Absperrorgan und das Kohlenstoff-Präkursor-Einlass-Absperrorgan insbesondere alternierend öffenbar sein. Dabei kann beispielsweise in einer Lithiierungsstellung das Lithium-Präkursor-Einlass-Absperrorgan geöffnet und das Kohlenstoff-Präkursor-Einlass-Absperrorgan geschlossen und einer Beschichtungsstellung das Lithium-Präkursor-Einlass-Absperrorgan geschlossen und das Kohlenstoff-Präkursor-Einlass-Absperrorgan geöffnet sein.

## Patentansprüche

1. Verfahren zur Herstellung eines Anodenaktivmaterials für eine Lithium-Zelle, in dem ein Anodenaktivmaterial, insbesondere teilweise lithiiert und mit Kohlenstoff beschichtet wird, **dadurch gekennzeichnet, dass** das Lithiieren und Beschichten mit Kohlenstoff alternierend wiederholt wird.

2. Verfahren nach Anspruch 1, **dadurch gekennzeichnet, dass** das Anodenaktivmaterial mittels chemischer Gasphasenabscheidung lithiiert wird.

3. Verfahren nach Anspruch 1 oder 2, **dadurch gekennzeichnet, dass** das, insbesondere teilweise, Lithiieren und Beschichten mit Kohlenstoff mindestens zehnfach wiederholt wird.

4. Verfahren nach einem der Ansprüche 1 bis 3, wobei das, insbesondere teilweise, Lithiieren und Beschichten mit Kohlenstoff bis zum Erreichen einer durchschnittlichen Schichtdicke der Kohlenstoffbeschichtung in einem Bereich von ≥ 50 nm bis ≤ 0,5 µm alternierend wiederholt wird.

5. Verfahren nach einem der Ansprüche 1 bis 4, wobei das Lithiieren und Beschichten mit Kohlenstoff bis zum Erreichen einer vollständigen Lithiierung des Anodenaktivmaterials alternierend wiederholt wird.

6. Verfahren nach einem der Ansprüche 2 bis 5, wobei das Anodenaktivmaterial, bezogen auf die durch das Anodenaktivmaterial maximal aufnehmbare stöchiometrische Lithiummenge, jeweils zu ≤ 20 %, insbesondere jeweils zu ≤ 5 %, teilweise lithiiert wird.

7. Verfahren nach einem der Ansprüche 1 bis 6, wobei bei dem Lithiieren des Anodenaktivmaterials mittels chemischer Gasphasenabscheidung ein Lithium-Präkursor verwendet wird, wobei der Lithium-Präkursor mindestens einen lithiierten Kohlenwasserstoff, insbesondere lithiiertes Acetylen und/oder lithiiertes Toluol, umfasst.

8. Verfahren nach einem der Ansprüche 1 bis 7, wobei das Anodenaktivmaterial mittels chemischer Gasphasenabscheidung mit Kohlenstoff beschichtet wird.

9. Verfahren nach Anspruch 8, wobei bei dem Beschichten des lithiierten Anodenaktivmaterials mittels chemischer Gasphasenabscheidung ein Kohlenstoff-Präkursor verwendet wird, wobei der Kohlenstoff-Präkursor mindestens einen Kohlenwasserstoff, insbesondere Acetylen und/oder Toluol umfasst.

10. Verfahren nach einem der Ansprüche 1 bis 9, wobei das Anodenaktivmaterial Silicium umfasst oder daraus ausgebildet ist.

11. Verfahren nach einem der Ansprüche 1 bis 10, **dadurch gekennzeichnet, dass** eine chemische Gasphasenabscheidungsvorrichtung (100) zur Herstellung des Anodenaktivmaterials für eine Lithium-Zelle verwendet wird, umfassend
- einen Reaktionsraum (110) zur Durchführung von chemischer Gasphasenabscheidung,
- einen Lithium-Präkursor-Einlass (120) zum Einlassen eines Lithium-Präkursors in den Reaktionsraum (110) und einem Lithium-Präkursor-Einlass-Absperrorgan zum öffenbaren Absperren des Lithium-Präkursor-Einlasses (120),
- einen Kohlenstoff-Präkursor-Einlass (130) zum Einlassen eines Kohlenstoff-Präkursors in den Reaktionsraum (110) und einem Kohlenstoff-Präkursor-Einlass-Absperrorgan zum öffenbaren Absperren des Kohlenstoff-Präkursor-Einlasses (130).

12. Verfahren nach Anspruch 11,
wobei in einer Lithiierungsstellung das Lithium-Präkursor-Einlass-Absperrorgan geöffnet und das Kohlenstoff-Präkursor-Einlass-Absperrorgan geschlossen ist, und/oder
wobei in einer Beschichtungsstellung das Lithium-Präkursor-Einlass-Absperrorgan geschlossen und das Kohlenstoff-Präkursor-Einlass-Absperrorgan geöffnet ist.

13. Anodenaktivmaterial für eine Lithium-Zelle, hergestellt durch ein Verfahren gemäß einem der vorhergehenden Ansprüche, umfassend Anodenaktivmaterialpartikel, insbesondere Siliziumpartikel, welche mit mindestens zwei lithiierten Kohlenstoffbeschichtungen beschichtet sind.

14. Lithium-Zelle, umfassend ein Anodenmaterial nach Anspruch 13.

## Claims

1. Method for producing an anode active material for a lithium cell, in which an anode active material is, in particular partially, lithiated and coated with carbon, **characterized in that** the lithiation and coating with carbon is repeated in alternation.

2. Method according to Claim 1, **characterized in that** the anode active material is lithiated by means of chemical vapour deposition.

3. Method according to Claim 1 or 2, **characterized in that** the, in particular partial, lithiation and coating with carbon is repeated at least ten times.

4. Method according to any of Claims 1 to 3, wherein the, in particular partial, lithiation and coating with carbon is repeated in alternation until an average layer thickness of the carbon coating in a range from ≥ 50 nm to ≤ 0.5 µm has been achieved.

5. Method according to any of Claims 1 to 4, wherein the lithiation and coating with carbon is repeated in alternation until complete lithiation of the anode active material has been achieved.

6. Method according to any of Claims 2 to 5, wherein the anode active material, based on the maximum stoichiometric amount of lithium that can be taken up by the anode active material, is partially lithiated each time to an extent of ≤ 20%, in particular each time to an extent of ≤ 5%.

7. Method according to any of Claims 1 to 6, wherein a lithium precursor is used in the lithiation of the anode active material by means of chemical vapour deposition, wherein the lithium precursor comprises at least one lithiated hydrocarbon, especially lithiated acetylene and/or lithiated toluene.

8. Method according to any of Claims 1 to 7, wherein the anode active material is coated with carbon by means of chemical vapour deposition.

9. Method according to Claim 8, wherein a carbon precursor is used in the coating of the lithiated anode active material by means of chemical vapour deposition, wherein the carbon precursor comprises at least one hydrocarbon, especially acetylene and/or toluene.

10. Method according to any of Claims 1 to 9, wherein the anode active material comprises or is formed from silicon.

11. Method according to any of Claims 1 to 10, **characterized in that** a chemical vapour deposition apparatus (100) is used for the production of the anode active material for a lithium cell, the apparatus comprising:
- a reaction chamber (110) for carrying out chemical vapour deposition,
- a lithium precursor inlet (120) for admitting a lithium precursor into the reaction chamber (110) and a lithium precursor inlet shut-off element for shutting off the lithium precursor inlet (120) in an openable manner,
- a carbon precursor inlet (130) for admitting a carbon precursor into the reaction chamber (110) and a carbon precursor inlet shut-off element for shutting off the carbon precursor inlet (130) in an openable manner.

12. Method according to Claim 11,
wherein in a lithiation position the lithium precursor inlet shut-off element is open and the carbon precursor inlet shut-off element is closed, and/or
wherein in a coating position the lithium precursor inlet shut-off element is closed and the carbon precursor inlet shut-off element is open.

13. Anode active material for a lithium cell, produced by a method according to any of the preceding claims and comprising anode active material particles, in particular silicon particles, which are coated with at least two lithiated carbon coatings.

14. Lithium cell comprising an anode material according to Claim 13.

## Revendications

1. Procédé pour la préparation d'un matériau actif d'anode pour une pile au lithium, dans lequel un matériau actif d'anode, en particulier est partiellement lithié et revêtu par du carbone, **caractérisé en ce que** la lithiation et le revêtement par du carbone sont répétés en alternance.

2. Procédé selon la revendication 1, **caractérisé en ce que** le matériau actif d'anode est lithié par dépôt chimique en phase gazeuse.

3. Procédé selon la revendication 1 ou 2, **caractérisé en ce que** la lithiation et le revêtement par du carbone, en particulier partiels, sont répétés au moins dix fois.

4. Procédé selon l'une quelconque des revendications 1 à 3, la lithiation et le revêtement par du carbone, en particulier partiels, étant répétés en alternance jusqu'à ce qu'une épaisseur de couche moyenne du revêtement de carbone dans une plage de ≥ 50 nm à ≤ 0,5 µm a été atteinte.

5. Procédé selon l'une quelconque des revendications 1 à 4, la lithiation et le revêtement par du carbone étant répétés en alternance jusqu'à ce qu'une lithiation complète du matériau actif d'anode a été atteinte.

6. Procédé selon l'une quelconque des revendications 2 à 5, le matériau actif d'anode étant partiellement lithié à chaque fois à raison de ≤ 20 %, en particulier à chaque fois à raison de ≤ 5 %, par rapport à la quantité stœchiométrique maximale de lithium pouvant être reçue par le matériau actif d'anode.

7. Procédé selon l'une quelconque des revendications 1 à 6, un précurseur de lithium étant utilisé lors de la lithiation du matériau actif d'anode par dépôt chimique en phase gazeuse, le précurseur de lithium comprenant au moins un hydrocarbure lithié, en particulier de l'acétylène lithié et/ou du toluène lithié.

8. Procédé selon l'une quelconque des revendications 1 à 7, le matériau actif d'anode étant revêtu par du carbone par dépôt chimique en phase gazeuse.

9. Procédé selon la revendication 8, un précurseur de carbone étant utilisé lors du revêtement du matériau actif d'anode lithié par dépôt chimique en phase gazeuse, le précurseur de carbone comprenant au moins un hydrocarbure, en particulier de l'acétylène et/ou du toluène.

10. Procédé selon l'une quelconque des revendications 1 à 9, le matériau actif d'anode comprenant du silicium ou étant formé à partir de celui-ci.

11. Procédé selon l'une quelconque des revendications 1 à 10, **caractérisé en ce qu'**un dispositif de dépôt chimique en phase gazeuse (100) est utilisé pour la préparation du matériau actif d'anode pour une pile au lithium, comprenant
- un espace de réaction (110) pour la réalisation d'un dépôt chimique en phase gazeuse,
- un orifice d'introduction (120) de précurseur de lithium pour l'introduction d'un précurseur de lithium dans l'espace de réaction (110) et un obturateur d'introduction de précurseur de lithium pour l'obturation susceptible d'être ouverte de l'orifice d'introduction (120) de précurseur de lithium,
- un orifice d'introduction (130) de précurseur de carbone pour l'introduction d'un précurseur de carbone dans l'espace de réaction (110) et un obturateur d'introduction de précurseur de carbone pour l'obturation susceptible d'être ouverte de l'orifice d'introduction (130) de précurseur de carbone .

12. Procédé selon la revendication 11,
dans lequel, dans une position de lithiation, l'obturateur d'introduction de précurseur de lithium est ouvert et l'obturateur d'introduction de précurseur de carbone est fermé, et/ou dans lequel dans une position de revêtement l'obturateur d'introduction de précurseur de lithium est fermé et l'obturateur d'introduction de précurseur de carbone est ouvert.

13. Matériau actif d'anode pour une pile au lithium, préparé par un procédé selon l'une quelconque des revendications précédentes, comprenant des particules de matériau actif d'anode, en particulier des particules de silicium, qui sont revêtues par au moins deux revêtements de carbone lithiés.

14. Pile au lithium, comprenant un matériau d'anode selon la revendication 13.
